Europäisches Patentamt

European Patent Office

Office européen des brevets

(11) Publication number: **0 166 343**
**B1**

# EUROPEAN PATENT SPECIFICATION

(45) Date of publication of patent specification: **01.02.89**

(21) Application number: **85107443.5**

(22) Date of filing: **19.06.85**

(51) Int. Cl.⁴: **H 01 L 29/36,** H 01 L 29/90

(54) A bistable ballistic space charge semiconductor device.

(30) Priority: **29.06.84 US 626370**

(43) Date of publication of application:
**02.01.86 Bulletin 86/01**

(45) Publication of the grant of the patent:
**01.02.89 Bulletin 89/05**

(84) Designated Contracting States:
**DE FR GB**

(56) References cited:
**EP-A-0 033 876**

**PROCEEDINGS OF THE EIGHTH BIENNIAL
CORNELL ELECTRICAL ENGINEERING
CONFERENCE, Cornell University, Ithaca, New
York, US, 11th-13th August 1981, pages 115-
124, IEEE, New York, US; K. BOARD et al.: "A
planar-doped barrier switching device"**

**APPLIED PHYSICS LETTERS, vol. 39, no. 4, 15th
August 1981, pages 340-342, American
Institute of Physics, New York, US; C.Y. CHEN
et al.: "Modulated barrier photodiode: A new
majority-carrier photodetector"**

(73) Proprietor: **International Business Machines
Corporation
Old Orchard Road
Armonk, N.Y. 10504 (US)**

(72) Inventor: **Solomon, Paul Michael
2220 Brookside Avenue
Yorktown Heights New York 10598 (US)**

(74) Representative: **Hobbs, Francis John
IBM United Kingdom Limited Intellectual
Property Department Hursley Park
Winchester Hampshire SO21 2JN (GB)**

(56) References cited:
**MICROELECTRONICS JOURNAL, vol. 13, no. 4,
July/August 1982, pages 19-22, Benn
Electronics Publications Ltd., Kirkcaldy, GB; K.
BOARD: "A review of bulk unipolar diodes and
their applications"**

**SOLID-STATE ELECTRONICS, vol. 25, no. 9,
September 1982, pages 943-945, Exeter, GB; S.
LURYI et al.: "Optimum BARITT structure"**

Courier Press, Leamington Spa, England.

(56) References cited:

PROCEEDINGS OF THE EIGHTH BIENNIAL CORNELL ELECTRICAL ENGINEERING CONFERENCE, Cornell University, Ithaca, New York, US, 11th-13th August 1981, pages 87-96, IEEE, New York, US; R.J. MALIK et al.: "GaAs planar-doped barrier transistors grown by molecular beam epitaxy"

TECHNICAL DIGEST OF THE 1979 INTERNATIONAL ELECTRON DEVICES MEETING, Washington, D.C., US, 3rd-5th December 1979, pages 388-389, IEEE, New York, US; C.E.C. WOOD et al.: "Hyper-thin channel M.B.E. GaAs power F.E.T.s by single atomic plane doping"

**Description**

This invention relates to a bistable ballistic space charge semiconductor device.

As the rate of response of semiconductor dervices approaches $10^{-12}$ seconds, the drift mechanism that has traditionally been the means of carrier transport in the semiconductor is not sufficiently fast and is limiting performance.

The use of ballistic carrier transport in which a carrier is lauched across a heterojunction into a region of semiconductor material under conditions such that the carrier has a high energy is an approach currently receiving attention in the art to achieve the desirable $10^{-12}$ second response. Such a carrier injection mechanism in a device is described in Proc. IREE *70*, No. 1, Jan. 1982, pp. 13 to 25. This type of injection mechanism has come to be known in the art as a ballistic launcher.

Another approach for high speed performance involves the use of a special barrier that is the result of impurity profile changes over a short distance. Such an abrupt change has an accompaning triangular energy band relationship. This type of barrier is known in the art as a planar doped barrier. An example of a device employing this type of barrier is described in Electronics Letters *16*, No. 22, 23 Oct. 1980, p. 836 to 838. One of the features of a device of this type is that it exhibits virtually constant capacitance over the entire operating range. A bistable form of switching device which is based upon regenerative interaction between a planar doped barrier and some form of hole injector such as a p-n junction, or a Schottky barrier, has been described in Proc. Eight Biennial Cornell Electrical Engineer Conference, 11 to 13 August, 1981, IEEE, New York, p. 115—124.

According to the invention, there is provided a ballistic space charge semiconductor device comprising a low conductivity near intrinsic region sandwiched between a heavily doped carrier injection region of one conductivity type and a heavily doped output region of the same conductivity type, the carrier injection region being comprises of semiconductor material having a wider band gap than that of which the near intrinsic region is comprised; and a doped planar barrier of said one conductivity type disposed in the near intrinsic region, the doped planar barrier being adjacent and parallel to the interface between the carrier injection region and the near intrinsic region.

How the invention can be carried out will now be described by way of example, with reference to the accompanying drawings, in which:

FIG. 1 is a schematic diagram of a device embodying the invention;

FIG. 2 is an energy level diagram showing a conduction band discontinuity across a heterojunction employable as a ballistic launcher;

FIG. 3 is an energy level diagram showing a tunneling barrier together with a conduction band discontinuity employable as a ballistic launcher;

FIG. 4 is an illustration of the change in charge at a planar doped barrier;

FIG. 5 is an illustration of the change in field at a planar doped barrier;

FIG. 6 is an illustration of the variation in potential across a planar doped barrier;

FIG. 7 is an energy level band diagram dimensionally correlated with FIGS. 1 to 6;

FIG. 8 is a schematic illustration of the currents in the potential well at the heterojunction interface;

FIGS. 9 and 10 are illustrations of the effect of electron collisions in the potential well at the heterojunction interface for potential wells of different depth; and

FIG. 11 is an illustration of bistable operation characteristics of the device of FIG. 1.

A $10^{-12}$ second switching bistability is provided in a semiconductor device by forming a ballistic launcher type of injection mechanism adjacent to a planar doped barrier. Ther resulting structure has charge characteristics at the ballistic launcher interface that are different at different times and which give rise to different stabilities.

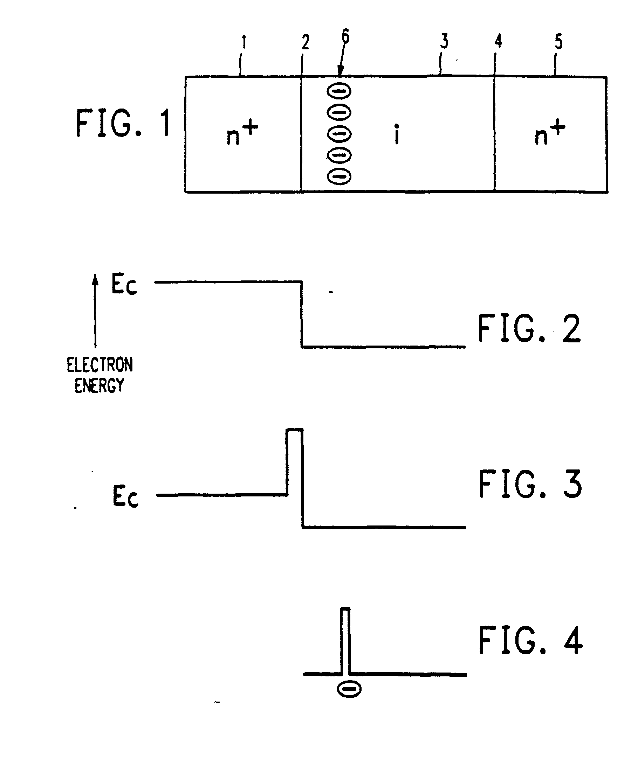

Referring to FIG. 1, a semiconductor structure has a first cathode region 1 having a high conductivity, shown as $n^+$. The region 1 is epitaxially joined at an interface 2 with a region 3 which is substantially intrinsic or undoped, shown as i. The band relationships at the interface 2 are such that electrons injected across the interface have high energy in region 3. The region 3 is epitaxially joined at an interface 4 with a high extrinsic conductivity anode region 5 shown as $n^+$. External ohmic contracts, not shown, would be applied to regions 1 and 5 for circuit purposes.

A planar doped barrier 6 shown as a line of negative charges is provided in the intrinsic region 3 adjacent to the interface 2 i.e. a thin doped region. The presence of the planar doped barrier 6 adjacent to the interface 2 provides charge conditions that gives rise to bistable performance.

FIG. 2 represents a conduction band discontinuity that is arranged to occur across the interface 2 to provide a ballistic launcher. Such a condition is easily achieved by providing region 1 with a wiser band gap and region 2 with a narrower band gap. In order to limit currrent from the ballistic launcher a thin tunneling barrier, as shown by the energy diagram of FIG. 3, is provided in the region 1 adjacent to the interface to serve as a voltage controllable barrier to carrier injection.

A planar doped barrier when positioned adjacent to a ballistic launcher interface provides a controllable content potential well. The control of the content of the potential well provides circuit performance advantages including bistability.

Referring next to FIGS. 4, 5 and 6, the charge, the field and the energy diagram at the planar doped barrier 6, are respectively shown each dimensionally correlated with FIG. 1.

The effect of the barrier 6 is to divide the region 3 into a space charge region located between the barrier 6 and the interface 2 and a drift region located between the barrier 6 and the interface 4.

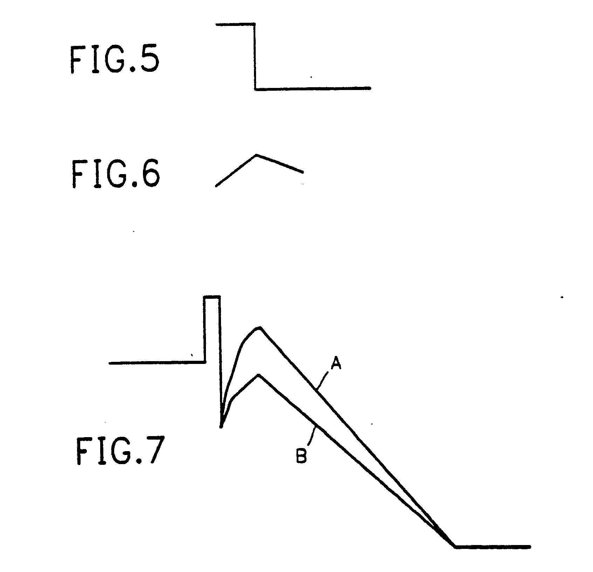

The structure of FIG. 1, with the physical conditions in place exhibits bistable performance. The performance is illustrated in connection with FIG. 7, in which a dimensionally correlated band energy diagram is provided for the structure of FIG. 1 under the influence of bias. The first stable state involves high charge low current and the band is labelled A and the second state involves low charge high current with the band labelled B.

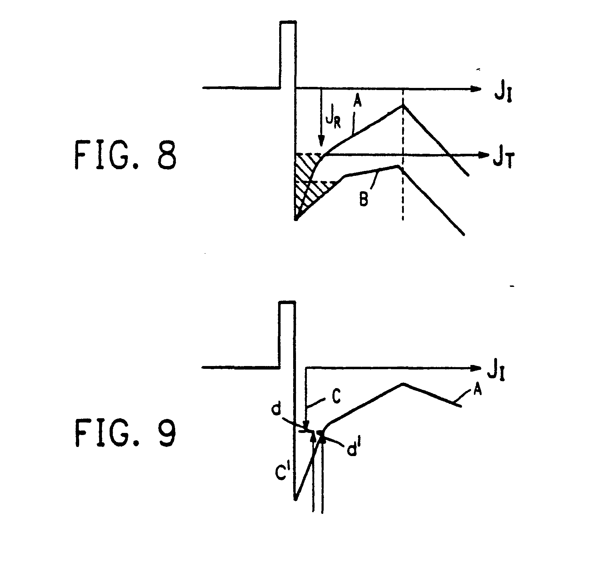

The bistable characteristics of the device involves several mechanisms illustrated schematically in FIG. 8. Referring to FIG. 8, the band energy levels for curves A and B are shown in the region from the ballistic launcher interface across the planar barrier. The respective currents are given the symbols J. The band relationships define a potential well which is a condition where energy is required to move an electron from a localized area. The first mechanism involves confinement characteristics of the charge in the potential well. The second mechanism involves impact ionization of the electrons in the space charge region by current carrying electrons.

The confinement mechanism may be considered by referring in FIG. 8 to the injected current $J_I$ which is introduced from the ballistic launcher. Of this $J_I$ current, there will a portion labeled $J_R$ that supplies electrons to the potential well to overcome energy loss due to such losses as optical phonons, and electron to electron interactions. The electrons trapped in the well can also tunnel out with a tunneling current shown as $J_T$. Other losses can occur by thermionic emission. For simplicity, thermal losses can be assumed to be negligible.

The stability of the charge in the well is given by the ratio $J_R/J_T$. For the condition where $J_R/J_T$ is greater than 1, electrons will accumulate in the potential well. For the condition where the ratio $J_R/J_T$ is less than 1, electrons will be depleted from the well.

An instability mechanism is associated with the structure because the more electrons there are in the potential well, the narrower the well becomes and the wider and higher the potential barrier 6 becomes. This is shown in FIG. 8 where the barrier is wider and higher in the high charge low current condition labeled A compared with the low charge high current condition labeled B even though in the B condition the potential well contains more electrons. In other words, the more electrons there are, the less likely they are to escape.

The second or impact ionization mechanism concerns the current $J_R$ that is feeding into the potential well. A major loss mechanism of the $J_I$ current carrying electrons is electron-to-electron collisions with electrons that are in the potential well.

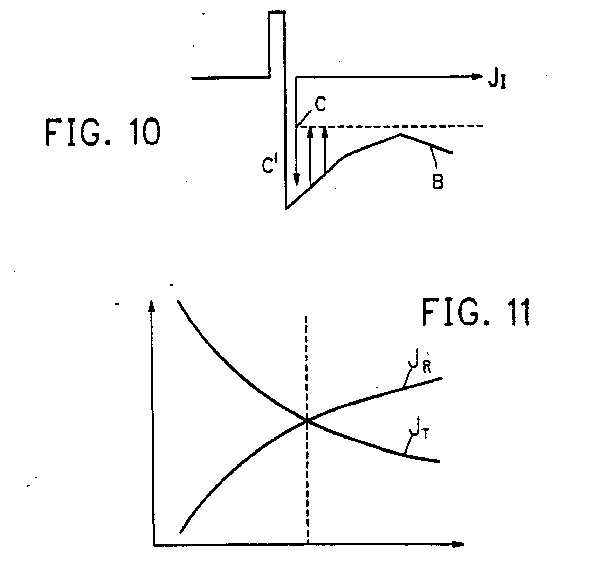

Referring to FIGS. 9 and 10, the conditions in the potential well for the current conditions A and B respectively are shown. In FIG. 9, an electron c interacts or collides with electron c' resulting in the two electrons then having energies d and d' each with about one-half of the kinetic energy of electron c. Thus, for the condition A where the well is deep and narrow, electrons d and d' do not have on the average enough energy to be emitted out of the well. In comparison in FIG. 10 where the well is narrower, they do. The net current feeding the well decreases and may even become negative, that is, two electrons leave for one entering as the well becomes shallower. That is, the more electrons there are in the well, the more current there is to build up the well.

The combined result of the two mechanisms is shown in FIG. 11. There is a point of instability where $J_T = J_R$ at some critical electron concentration to a value $n_{er}$ where n is the number of electrons in the well. For the condition where $n > n_{er}$ then $J_R > J_T$ and the well will build up eventually to the Fermi energy of the ballistic injector. For the condition where $n < n_{er}$ then $J_R < J_T$ and the well will collapse. The point of instability is shown as a dotted line where the current values $J_R$ and $J_T$ cross in FIG. 11. This instability mechanism may be employed in various applications, the most promising being a high frequency device such as a millimeter wave oscillator. In such a device the current densities are high, the resistances are low and the device dimensions are small.

In a preferred embodiment of the invention, the cathode region 1 is of GaAlAs, where the amount of Al in the approximately 10 nm region adjacent the interface 2 is greater than the amount of Al in the rest of the region 1 to produce the tunneling barrier of FIG. 3. Region 3 is semi-insulating GaAs, very lightly doped, epitaxial at the interface 2 with the region 1, the planar barrier 6 is a thin doping of germanium, and the anode type region 4 is of GaAs, heavily doped with about $10^{19}$ atoms per $cm^3$ of tellurium. The distance from the interface 2 to the barrier 6, i.e. the space charge region, is about 10 nanometers and the distance from the barrier 6 to the interface 4, the drift region, is about 100 nanometers.

What has been described is a device in which a planar barrier is disposed in an intrinsic semiconductor region adjacent to a ballistic interface. The intrinsic region is thus divided into a space charge and a drift region such that electrons stored in a potential well adjacent the interface contribute to two different output current characterists which may be employed in a bistable device.

## Claims

1. A bistable ballistic space charge semiconductor device comprising a low conductivity near intrinsic region (3) sandwiched between a heavily doped carrier injection region (1) of one conductivity type and a heavily doped output region of the same conductivity type (5), the carrier injection region being comprised of semiconductor material having a wider band gap than that of which the near intrinsic region is comprised; and a doped planar barrier (6) of said one conductivity type disposed in the near intrinsic region, the doped planar barrier being adjacent and parallel to the interface (2) between the carrier injection region and the near intrinsic region.

2. A device as claimed in claim 1, in which the planar barrier (6) is disposed about 10 nm from the interface (2) between the carrier injection region (1) and the near intrinsic region (3) and about 100 nm from the interface (4) between the near intrinsic region and the output region (5).

3. A device as claimed in claim 1 or claim 2, in which the near intrinsic region (3) is comprised of gallium arsenide.

4. A device as claimed in claim 3, in which the near intrinsic region (3) has a planar section doped with germanium to provide the doped planar barrier (6).

5. A device as claimed in claim 3 or claim 4, in which the carrier injection region (1) is comprised of GaAlAs.

6. A device as claimed in claim 5, in which the amount of Al is a portion about 10 nm thick of the carrier injection region (1) adjacent the interface (2) is greater than in the rest of the carrier injection region.

7. A device as claimed in any of claim 3 to 6, in which the output region (5) is comprised of gallium arsenise doped with $10^{19}$ atoms per cm$^3$ of tellurium.

## Patentansprüche

1. Bistabiles ballistisches Raumladungszonen-Halbleiterbauelement mit einem eine niedrige Leitfähigkeit aufweisenden Fast-Eigenleitungs-Bereich (3), der zwischen einem stark dotierten Ladungsträgerinjektionsbereich (1) eines Leitfähigkeitstyps und einem stark dotierten Ausgangsbereich (5) desselben Leitfähigkeitstyps eingefügt ist, wobei der Ladungsträgerinjektionsbereich aus einem Halbleitermaterial besteht, welches einen größeren Bandabstand aufweist als, das, aus dem der, Fast-Eigenleitungs-Bereich besteht; und mit einem dotierten flächigen Potentialwall (6) des besagten einen Leitfähigkeitstyps, der in dem Fast-Eigenleitungs-Bereich angeordnet ist, wobei sich der dotierte flächige Potentialwall benachbart und parallel zu der Grenzfläche (2) zwischen dem Ladungsträgerinjectionsbereich und dem Fast-Eigenleitungs-Bereich erstreckt.

2. Bauelement nach Anspruch 1, bei dem der flächige Potentialwall (6) ungefähr 10 Nanometer von der Grenzfläche (2) zwischen dem Ladungsträgerinjektionsbereich (1) und dem Fast-Eigenleitungs-Bereich (3) und ungefähr 100 Nanometer von der Grenzfläche (4) zwischen dem Fast-Eigenleitungs-Bereich und em Ausgangsbereich (5) angeordnet ist.

3. Bauelement nach Anspruch 1 oder 2, bei dem der Fast-Eigenleitungs-Bereich (3) aus Galliumarsenid besteht.

4. Bauelement nach Anspruch 3, bei dem der Fast-Eigenleitungs-Bereich (3) einen flächigen, mit Germanium dotierten Abschnitt aufweist, um den dotierten flächigen Potentialwall (6) zu schaffen.

5. Bauelement nach Anspruch 3 oder 4, bei dem der Ladungsträgerinjektionsbereich (1) aus GaAlAs besteht.

6. Bauelement nach Anspruch 5, bei dem die Menge des Al in einem ungefähr 10 Nanometer dicken Abschnitt des an die Grenzfläche (2) angrenzenden Ladungsträgerinjektionsbereichs (1) größer ist als im Rest des Ladungsträgerinjektionsbereichs.

7. Bauelement nach einem der Anspruch 3 bis 6, bei dem der Ausgangsbereich (5) aus Galliumarsenid besteht, das mit $10^{19}$ Atomen pro cm$^3$ Tellurium dotiert ist.

## Revendications

1. Dispositif semi-conducteur à charge d'espace balistique bistable comprenant une région presque intrinsèque de faible conductivité (3) interposée entre une région d'injection de porteurs fortement dopée (1) d'un premier type de conductivité et une région de sortie fortement dopée (5) du même type de conductivité, la région d'injection de porteurs étant constituée de matière semiconductrice ayant un intervalle de bande plus large que celui de la matière dont est constituée la région presque intrinsèque; et un barrière planaire dopée (6) dudit premier type de conductivité, disposée dans la région presque intrinsèque, la région planaire dopée étant adjacente et parallèle à l'interface (2) entre la région d'injection de porteurs et la région presque intrinsèque.

2. Dispositif suivant la revendication 1, dans lequel la barrière planaire (6) est disposée à 10 nm environ de l'interface (2) entre la région d'injection de porteurs (1) et la région presque intrinsèque (3) et à 100 nm environ de l'interface (4) entre la région presque intrinsèque et la région de sortie (5).

3. Dispositif suivant la revendication 1 ou la revendication 2, dans lequel la région presque intrinsèque (3) est constituée d'arséniure de gallium.

4. Dispositif suivant la revendication 3, dans lequel la région presque intrinsèque (3) présente une section planaire dopée avec du germanium pout constituer la barrière planaire dopée (6).

5. Dispositif suivant la revendication 3 et la revendication 4, dans lequel la région d'injection de porteurs (1) est constituée de GaAlAs.

6. Dispositif suivant la revendication 5, dans lequel la concentration en Al dans une partie de 10 nm d'épaisseur environ de la région d'injection de porteurs (1) adjacente à l'interface (2) est supérieure à la concentration en Al dans le reste de la région d'injection de porteurs.

7. Dispositif suivant l'une quelconque des revendications 3 à 6, dans lequel la région de sortie (5) est constituée d'arséniure de gallium dopé avec $10^{19}$ atomes par cm$^3$ de tellurium.

FIG. 1

FIG. 2

FIG. 3

FIG. 4

FIG.5

FIG.6

FIG.7

A

B

FIG. 8

FIG. 9

FIG. 10

FIG. 11